# EUROPEAN PATENT APPLICATION

(11) **EP 3 026 508 A1**
(43) Date of publication of application: **01.06.2016**
(21) Application number: 14194785.3
(22) Date of filing: 25.11.2014
(51) Int. Cl.: G05B 15/02, F03D 7/04, G06Q 10/04, H05K 7/20

(54) **Method and system for determining optimized operation of a component of an automation system**

(71) Applicant: Siemens Aktiengesellschaft, 80333 München (DE)
(72) Inventor: Bredekamp, Adriaan Hendrik, 76344 Eggenstein-Leopoldshafen (DE); Hackstein, Holger, 63128 Dietzenbach (DE)

(57) **Abstract**

The invention is related to a method and corresponding system for determining optimized operation of a hardware component of a control system of an automation system of a technical installation. After determination of relevant parameters and conditions, optimum placement of each component with respect to resource utilization, data throughput, response time and overload of any single component is calculated, based on the determined parameters and conditions of each individual component and of the sum of components. This way load balancing between the components used is achieved. In a preferred embodiment the optimization method is adapted for applications using simple I/O devices in connection with cloud or Storm computing services.

## Description

The invention is related to a method and corresponding system for determining optimized operation of a component of an automation system of a technical installation.

Due to the tremendous progress in computer technology future automation systems may be configured in novel ways. One possibility is to move more signal processing towards the field devices having more intelligent Input/Output devices (I/O devices). Another possibility is to move the processing of signals and data away from the end-devices to large groups of remote servers with their services using techniques like cloud or Storm computing. Storm computing (http://www.wealth daily.com/articles/storm-computinq-the-next-tech-boom/3237, http://www.slideshare.net/nathanmarz/storm-distributed-and-faulttolerant-realtime-computation) is a next generation cloud which has the characteristics that it has a real-time behavior; it is fault-tolerant and distributed. In effect the cloud as it is used today provides massive data handling capability and a Storm cloud adds the capability to also process the massive amount of data in real-time without losing data (fault-tolerant) and in a distributed manner (meaning shortest delay to the actual processing node) thus being especially suitable for automation purposes in the field of power generation.

In the case of automation, it is necessary to move data and to be able to process large volumes of data quickly and in real-time. Moving processing and storage into the cloud means that only the bare minimum of analog electronics and data converters (analog to digital or digital to analog) are essentially remaining in the cabinets of the automation system hardware. This means that in future only small modules will suffice to handle all the data and processing needs imaginable. Since they are now also all looking similar, a universal I/O device or a universal processing unit is created.

The new problem is with handling all these new I/O devices, especially in automation where physical hardware is involved to get signals from sensors or to send signals to actuators. In a power station it means that 100's of front-end electronic units are suddenly replaced with simpler systems that are connected to the Storm cloud. These are general purpose end-points (spouts in Storm jargon) meaning that they can handle any kind of data. The term "spout" is used in Storm documentation to denote a "source of streams". In reality they have an analog input or output, some converter between analog and digital data and a communications interface. They are then built into cabinets and now the problem is created that needs to be solved. These spouts or universal front-end electronics each generate heat and based on location they also have an influence on the power supplies that are installed in each cabinet. There are also considerations of networking capacity since larger volumes of data are now transmitted from a local point. The physical problem is that smaller devices are packed into the same space where fewer larger devices were previously installed.

Storm causes a simplification on the front-end side since processing and storage is moved out of the cabinets all away into the cloud. The I/O devices or spouts are reduced to just the bare basics which reduces the I/O device cost and the total system cost since expensive components could be deleted. Previously you had different kinds of I/O devices for each task which made some device bulky and the placement could not be optimized. Local processors and storage units were needed.

The existing state of the art is to add cheaper processors in the front-end I/O device that can do more, which is exactly the opposite of Storm. These front-end processors are most of the time also not used optimally and increase the bulk size of the system. Switching to Storm reduces cost and engineering effort due to the simpler systems (I/O complexity reduction) Reducing the size to half, however, does not mean you reduce the power consumption to half. This means the power supplies were previously not loaded to the maximum and the heat generated was also less since the cabinets were not filled to the maximum with electronics.

Therefore the invention is based on the problem of providing a method and system that allows optimized operation of hardware components of a control system of a technical plant, especially of I/O devices or processing units adapted for applications in connection with cloud or Storm computing services.

This problem is solved inventively by a method comprising the steps as outlined in claim 1 and a system comprising features as outlined in claim 8.

Optimized placement of hardware components is a fundamental requirement for optimized operation and performance of each component itself and for groups of relevant components in a technical installation. It implies numerous advantages in a technical and economical view. Optimization here is meant to be as comprehensive as possible. Purely physical aspects of the plant environment and hardware components of a plant control system shall be included just as load balancing. Here the term "load balancing" is understood in the sense to optimize resource use, maximize throughput, minimize response time, and avoid overload of any single resource or component. As a result energy consumption can be reduced if intelligent placement of components prevents for instance the application of additional fans or cooling mechanisms. Costs can be saved if for example the number of hardware components is reduced by fitting smaller components such as universal processing units or so-called spouts into less cabinets. Even aspects as costs for the real-estate needed in a power station can lead to a real market advantage if cabling trenches can be reduced.

In an advantageous embodiment optimization takes place during commissioning of the technical installation. This offers the highest degree of freedom as to placement of each hardware component.

If optimization is performed during operation of the technical installation, it is a large advantage that required adjustments can be applied quickly, for example after a re-engineering of a plant. Parameter changes or amendments in the configuration are without problem because the optimization program will calculate the best placement for each component.

In a preferred embodiment parameters and other relevant values are stored in a database. This way a repetitive and elaborate determination of a plurality of parameters can be saved.

In a further preferred embodiment cost aspects are taken into account. This could be by adding additional factors or values into the optimization routine, such as price for electricity, prices for equipment, devices, network services etc.

The inventive method has been developed especially for hardware components of a control system comprising universal Input/Output devices which are used here in synonym to processing units, control cabinets, interface modules, switchboxes or marshalling cabinets. The inventive method is especially effective for the above-mentioned spouts which are used in connection with Storm computing.

Optimized operation or placement of components within an automation system of a technical installation is preferably achieved by a system according to claim 8.

In the following text, an exemplary embodiment of the solution according to the invention is explained in more detail on the basis of the attached schematic drawing, wherein:

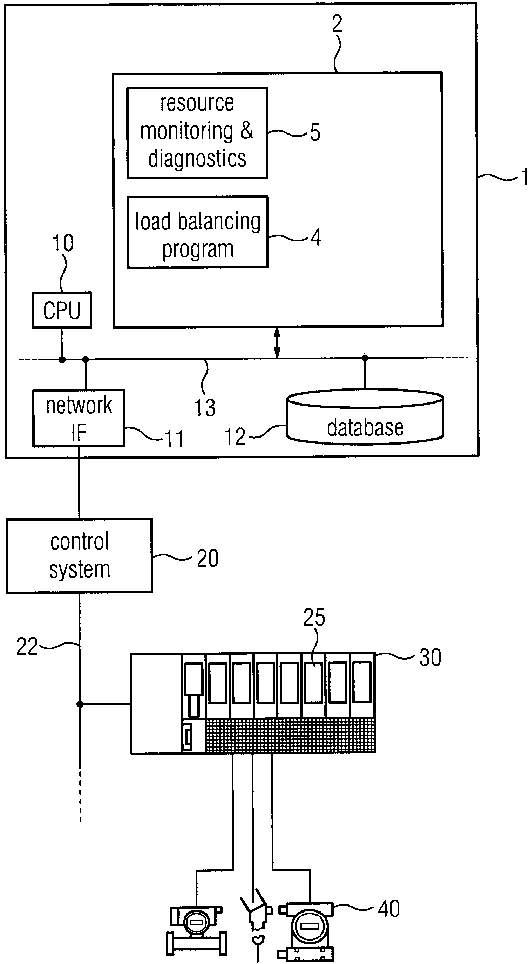

The only figure shows an exemplary embodiment of the inventive system for optimized component placement.

The figure shows a block diagram illustrating components of a system 1 for determining optimized placement of a component of an automation system of a technical installation, the system being connected to a control system 20 of a technical plant.

Such a system 1 may include but is not limited to a central processing unit (CPU) 10, a memory 2, a network interface 11, a database 12 as storage medium and a data bus 13. The memory 2 includes several programs which are computer programs stored in the storage medium, copied from the storage medium to the memory and executed in the CPU. The various programs in this disclosure may instead be modules implemented in software, firmware or hardware or the like. Commands and data communicated between CPU and other components are transferred via the data bus 13. Communication with a network or other systems takes place over the network interface 11.

System 1 for determining optimized placement of hardware components of a control system of a technical plant may either be integrated into the control system itself or be realized as separate system or module as illustrated in the figure (where a display or output unit is not shown). In the latter case a communication connection is necessary to provide the necessary data transfer between control system 20 and system 1. Usually a control system 20 is connected via a high-speed field bus 22 (such as a PROFIBUS DP) to further hardware components of the control system such as control cabinets 30, switchboxes or marshalling cabinets or other decentral peripheral devices. The cabinet 30 includes a plurality of processing units 25 and is usually placed near field devices 40 such as pumps, transducers or other devices including sensors and/or actuators.

In the described embodiment the operation of I/O devices is optimized by optimizing their placement especially with respect to load balancing. At the same time the inventive method could be used for optimized placement of cabinets too. Any placement of a hardware component of the technical installation could be taken into account. Since the optimization also takes into account data flow and distribution, an optimized performance is directly coupled with the issue. Cost aspects additionally can be included in the calculation.

In a first step of the inventive method for determining optimized operation by placement of a hardware component of a plant control system of a technical installation, a plurality of necessary parameters, values or magnitudes are determined.

Input parameters for the optimization procedure can be divided into several groups:
1) Environmental parameters at the location of the technical installation such as temperature, humidity, noise, vibrations;
2) Parameters concerning the construction of the plant, hardware of the plant control system such as cabinets, switch boxes, marshalling cabinets, location and characteristics of sensors and actuators, field devices such as pumps, transducers or cable trench routes;
3) Parameters in relation with a cabinet: cabinet temperature, cabinet humidity, location of the cabinet, air flow, vibration, power supply;
4) Parameters in relation with an universal processing unit: current consumption, power supplies, voltages needed, generated heat;
5) Data and network parameters: data rate, data volume, processing power, clock speed, network load, capacity of switches and routers, network data connection;
6) Parameters out of the engineering of the plant control system;

The necessary parameters can be either stored in the database 12 of the inventive system 1 or they can be stored in the control system 20 and transmitted to system 1. Another option would be that those parameters are measured at predetermined locations within the technical installation or that the hardware components whose placement is to be optimized deliver those parameters themselves. As a result the environmental conditions at the location of the technical installation are determined just as parameters and characteristics of the hardware component whose placement is to be optimized.

The input parameters are then fed into the load balancing program 4 calculating the optimum placement of the component with respect to resource utilization, data throughput, response time and overload of any single component based on the determined parameters and conditions of each individual component and the sum of the components and outputting the optimized placement of the component within the technical installation.

For the case that there are universal processing units which have to be placed in a number of cabinets in an optimized way, there are several scenarios possible. In the embodiment described the processing units shall be "spouts", which are simple constructed I/O-modules adapted to be used for Storm computing and acting as data sources or even as source of data streams. There are now also parameters for cabinet temperature, air-flow, power supply rating and current consumption but also what the neighboring cabinets have for capacity needs to be known. The processing power needed can also be adjusted by reducing the clock speed for a specific application. A simple temperature measurement has fewer needs than a diagnostics channel that calculates a FFT. Reducing the clock speed for a certain application, means less power consumption, which means less heat generated. This sounds counter intuitive since the processing was moved into the cloud, but the data converter used also has a clock speed and sampling at 10 Hz uses less power than the same data converter for diagnostics that reads data for that FFT calculation.

It means that the I/O-modules of this embodiment with high performance and lower performance can be mixed in a cabinet to optimize the heat generated and power consumption. In the same way you can also optimize the data stream leaving the network from a cabinet by mixing lower data and high data rate processing units which also has again an influence on the power consumption. It might then be needed to move an I/O device to a neighboring cabinet just to adjust temperature, power consumption but also network load. The network load is also dependent on the capacity of the switches and routers that is part of the network again, meaning that by moving an I/O device to a neighboring cabinet would have the cost implication that a new switch has to be installed, causing a large negative cost effect on the placement of that I/O device in a specific cabinet. Added to that the location of the cabinet in relation to the sensor position and the optimal network data connection would also be a parameter that can be optimized.

It is advantageous if the load balancing program comprises a graphical view of the plant where also the limitations can be entered such as noise, heat, cable trench routes etc. and the loads produced by each I/O module such as heat or data. This program needs to have a database containing information on what the projected consumption values are for power, generated heat and data produced are. The projected data can then be correlated with real measurement data in the cabinets for power, heat and data volume. This comparison can then be actively monitored by a cabinet diagnostic system which would allow the testing of the optimization but also the indirect health monitoring of the installed equipment. Therefore a resource monitoring and diagnostics tool 5 can be added to the inventive system in order to provide continuous supervision of the hardware components in question. Cabinet Diagnostic systems monitoring heat and/or current could also be used to optimize their processing. Optimization can also occur at run-time by processing load distribution. Optimization further can be based on the characteristics of the sum of the hardware components and each individual component. Another choice would be to optimize the placement of a component on a per channel basis.

In the following further examples of embodiments of the invention shall be given:

Example 1: In order to design a power station for example, a physical map is produced of the inside of the power station showing the cable routing lengths, the location of the cabinets, the location of the sensors along with environmental parameters like temperature and routing obstacles (i.e. high voltage cables that will influence sensor cables). Since all IOs (= processing units) are now similar, independently of what will be, the designer enters the requirements for the IO that he needs (i.e. 200x temperature, 100x pressure, 25x diagnostic vibration) into the system and marks their location on the computer map along with the location of all equipment cabinets that are available. Let's assume that a central compressor has 3 cabinets 100 meters to the north and 2 cabinets 110 meters to away to the south. This compressor needs 20 temperature, 10 pressure and 10 vibration signals. The other signals are already installed half-half in the north and south cabinets. That is 26 per cabinet north and 80 per cabinet south. The same distribution can be done for pressure and vibration. Since the north cabinets are mostly still empty, the sensor end-points can be installed there over 3 cabinets. That would increase the temperature sensors per cabinet to the north from -26 to -35 (same increase for pressure and vibration can be added). If it's assumed that the north cabinets are standing in a location where the ambient temperature is really high (next to a furnace for instance), and adding each IO increase the temperature by 1° C. Adding the 7 temperature IOs would raise the ambient temperature by 7° C. If the limit left was only 3° C, then only 3 IOs could be added and all the rest of the IOs would need to be placed in the south cabinets, although they are already nearly full. The same optimization can be done again by saying that adding each IO requires an extra 10 mA from the power supply which can only deliver 10 Ampere. A third variable can be added in that each IO produces a network traffic of 100 Kbits/s and the network switch can handle only 1 Gbit/s. In this way more and more optimization variables can be added. Other examples are for cost of cable length per meter, the network cable transmission length of 100 meters or electronic noise level. In the last case a sensitive measurement needs a low noise level meaning the needs to be either very close to the measurement point or further away depending on the measurement type.

Example 2: Two cabinets standing next to each other each have 500 universal Storm IOs (universal IOs used along with Storm computing) installed. Both have the same temperature (due to some IOs being clocked higher and others lower in the cabinets) and both cabinets have the same current consumption. Cabinet A produces a data stream of 300 Mbit/s to an Ethernet router and cabinet B a data stream of 200 Mbit to a different Ethernet router. In order to install more IOs that produce an additional 50 Mbit of data/second and an additional 2% of power dissipation, cabinet B would be the obvious choice.

Both examples like the above using the given invention idea, will result in a kind of balancing, either on energy consumption, heat generation, network load/traffic, etc. The new aspect underlying this invention is that those kinds of balancing is currently only known from so called cloud applications, in which the "load" balancing is to equal the calculation or storage power within a virtual computer net framework. This invention is different in which a new kind of I/O concept is required to balance as given above.

## Claims

1. Method for determining optimized operation of a component of an automation system of a technical installation,
the component comprising a hardware component (25, 30) of a control system,
the method comprising steps of
- determining environmental conditions at the location of the technical installation,
- determining parameters and characteristics of the component,
- determining data and network conditions,
- calculating the optimum placement of the component with respect to resource utilization, data throughput, response time and overload of any single component based on the determined parameters and conditions of each individual component and the sum of the components and,
- outputting the optimized placement of the component within the technical installation.

2. The method according to claim 1,
where optimization takes place during commissioning of the technical installation.

3. The method according to claim 1,
where optimization is performed during operation of the installation.

4. The method according to claim 1, 2 or 3,
where parameters and other relevant values are stored in a database.

5. The method according to any of the preceding claims,
where a cost optimization is also included.

6. The method according to any of the preceding claims,
where the hardware components comprise universal processing units (25), control cabinets (30), interface modules, switchboxes or marshalling cabinets.

7. The method according to any of the preceding claims, where the hardware components comprise universal processing units for cloud computing or Storm computing.

8. System (1) for determining optimized operation of a component of an automation system of a technical installation,
the component comprising a hardware component of a control system, comprising
- a module (4) for calculating the optimum placement of the component with respect to resource utilization, data throughput, response time and overload of any single component based on input parameters and conditions of each individual component and the sum of the components and,
- a unit for outputting the optimized placement of the component within the technical installation.

9. The system according to claim 8
further comprising a module for resource monitoring and diagnostics (5).

10. The system according to claim 8 or 9,
further comprising a database (12) for storage of input parameters.

11. The system according to any of the preceding system claims, further comprising a cost optimization tool.

12. The system according to claim 8
where the hardware components comprise universal processing units (25), control cabinets (30), interface modules, switchboxes or marshalling cabinets.

13. The system according to claim 8,
where the hardware components comprise universal processing units for cloud computing or Storm computing.
